# EUROPÄISCHE PATENTSCHRIFT

(11) **EP 1 911 089 B1**
(45) Veröffentlichungstag und Bekanntmachung des Hinweises auf die Patenterteilung: **24.12.2008**
(21) Anmeldenummer: 06776455.5
(22) Anmeldetag: 27.07.2006
(51) Int. Cl.: H01L 23/00

(54) **ELEKTRONISCHES BAUELEMENT**
ELECTRONIC COMPONENT
COMPOSANT ELECTRONIQUE

(30) Priorität: 29.07.2005 DE 102005035590
(43) Veröffentlichungstag der Anmeldung: 16.04.2008
(73) Patentinhaber: PolyIC GmbH & Co. KG, 90763 Fürth (DE)
(72) Erfinder: ULLMANN, Andreas, 90513 Zirndorf (DE); KNOBLOCH, Alexander, 91052 Erlangen (DE); WELKER, Merlin, 91083 Baiersdorf (DE); FIX, Walter, 90427 Nürnberg (DE)
(74) Vertreter: Zinsinger, Norbert
(86) Internationale Anmeldenummer: PCT/EP2006/007442
(87) Internationale Veröffentlichungsnummer: WO 2007/014695

(56) Entgegenhaltungen:
- DE-A1- 10 338 277
- US-A- 5 707 894
- US-A1- 2001 006 846

## Beschreibung

Die Erfindung betrifft ein elektronisches Bauelement mit einem flexiblen Substrat, auf dessen Oberfläche ein Schichtstapel aus dünnen Schichten, enthaltend mindestens eine elektrische Funktionsschicht aus einem elektrisch leitenden oder halbleitenden Material, angeordnet ist, wobei das Bauelement mindestens ein erstes Material, ein schichtförmiges zweites Material und ein schichtförmiges drittes Material umfasst und wobei senkrecht zur Oberfläche des Substrats gesehen auf das erste Material das zweite Material folgt und auf das zweite Material das dritte Material folgt.

Derartige elektronische Bauelemente sind aus der DE 103 38 277 A1 bekannt, welche einen organischen Kondensator mit spannungsgesteuerter Kapazität beschreibt. Der organische Kondensator weist ein flexibles Substrat auf, auf welchem in Folge eine erste Elektrode, eine organische Halbleiterschicht, eine Isolatorschicht und eine zweite Elektrode angeordnet sind. Die Elektroden können dabei aus organischen, metallischen oder sonstigen elektrisch leitfähigen Materialien hergestellt sein. Die Isolatorschicht wird entweder aus einem organischen oder einem anorganischen elektrisch isolierenden Material gebildet. Die Spannungssteuerung der Kapazität wird zum einen durch die Halbleiterschicht und zudem durch eine geeignete Strukturierung der ersten Elektrode bewirkt.

Weiterhin offenbart die WO 2004/047144 ein organisches elektronisches Bauelement, insbesondere einen Feldeffekt-Transistor (OFET). Es ist ein OFET beschrieben, der ein Substrat und darauf in Folge Source/Drain-Elektroden, eine strukturierte organische Halbleiterschicht, eine isolierende Funktionsschicht und eine Gate-Elektrode aufweist. In der Massenproduktion von elektronischen Bauelementen mit organischen Funktionsschichten werden üblicherweise auf ein flexibles Substrat dünne organische, polymere und metallische Schichten aufgebracht. Das Substrat durchläuft dazu beispielsweise Bedampfungs- oder Sputteranlagen, Druck-, Umspul-, Schneide- oder Wickelmaschinen oder Bestückungsautomaten, wobei das flexible Substrat über verschiedene Walzensysteme geführt und dabei deformiert wird.

Die dabei auftretende mechanische Beanspruchung der auf dem Substrat aufgebrachten Schichten oder Schichtstapel kann bei einer mangelnden Haftung zwischen dem Substrat und der/den angrenzenden Schicht(en) oder zwischen aneinander im Schichtstapel angrenzenden Schichten zu teilweisen oder vollständigen Ablösungen von einer oder mehreren Schichten führen, was zu einer Beeinträchtigung der Funktionalität des Bauelements oder von Teilbereichen des Bauelements bis zu dessen Totalausfall führen kann. Häufig werden daher Haftvermittlerschichten eingesetzt, die die Haftung der unterschiedlichen Materialen aneinander verbessern sollen. Derartige Haftvermittlerschichten haben sich jedoch im Bereich der Elektronik, insbesondere im Bereich der Polymerelektronik, als oft störend erwiesen, da sie die Funktion eines elektronischen Bauelements beeinträchtigen können.

Aus der Druckschrift US 2001/0006846 ist ein elektronisches Halbleiterbauelement bekannt,
- mit einem Substrat, auf dessen Oberfläche ein Schichtstapel aus dünnen Schichten, enthaltend eine durch Abscheidung gebildete elektrische Funktionsschicht, nämlich eine n-dotierte amorphe Silizium-Schicht, angeordnet ist,
- wobei das Halbleiterbauelement ein erstes Material in Form einer Oxidschicht, ein zweites Material in Form einer Titannitridschicht, und ein drittes Material in Form einer Schicht aus n-dotiertem amorphem Silizium umfasst,
- wobei senkrecht zur Oberfläche des Substrats gesehen, auf das erste Material das zweite Material folgt und auf das zweite Material das dritte Material folgt,
- wobei eine erste Adhäsionskraft des zweiten Materials am ersten Material geringer ist als eine zweite Adhäsionskraft des dritten Materials am ersten Material, und
- dass das zweite Material Öffnungen aufweist, über welche das dritte Material mit dem ersten Material zur Erhöhung der Haftung des zweiten Materials am ersten Material, verbunden ist.

Es ist daher Aufgabe der Erfindung, die vollständige oder teilweise Ablösung einer oder mehrerer Schichten bei der Herstellung eines in Schichten aufgebauten elektronischen Bauelements, insbesondere eines organischen Bauelements, enthaltend mindestens eine elektrische Funktionsschicht aus einem elektrisch leitfähigen oder halbleitenden Material, ohne die Verwendung von Haftvermittlerschichten zu verhindern.

Die Aufgabe wird für ein elektronisches Bauelement, insbesondere ein organisches elektronisches Bauelement, mit einem flexiblen Substrat, auf dessen Oberfläche ein Schichtstapel aus dünnen Schichten, enthaltend mindestens eine gedruckte organische elektrische Funktionsschicht aus einem elektrisch leitenden oder halbleitenden Material, angeordnet ist, wobei das Bauelement mindestens ein erstes Material, ein schichtförmiges zweites Material und ein schichtförmiges drittes Material umfasst und wobei senkrecht zur Oberfläche des Substrats gesehen auf das erste Material das zweite Material folgt und auf das zweite Material das dritte Material folgt, dadurch gelöst, dass eine erste Adhäsionskraft des zweiten Materials am ersten Material geringer ist als eine zweite Adhäsionskraft des dritten Materials am ersten Material und dass das zweite Material mindestens eine Öffnung aufweist, über welche das dritte Material mit dem ersten Material zur Erhöhung der Haftung des zweiten Materials am ersten Material verbunden ist.

Durch eine derartige Ausgestaltung des elektronischen Bauelements gewinnt das schichtförmige zweite Material an Flexibilität und wird zudem im Bereich der mindestens einen Öffnung mittels des dritten Materials am ersten Material verankert beziehungsweise angeheftet. Nachdem das dritte Material besser als das zweite Material am ersten Material haftet, wird die gute Haftung des dritten Materials am ersten Material dazu genutzt, das zweite Material im Bereich der Öffnungen punktuell oder linienförmig zu fixieren. Dabei ergibt sich eine höhere Flexibilität des Bauelements und ein besserer Verbund der einzelnen Materialen im elektronischen Bauelement.

Die Gefahr, dass eine Deformation des flexiblen Substrats und darauf aufgebrachter Schichten bei der Herstellung des elektronischen Bauelements zu einer vollständigen oder bereichsweisen Ablösung von Schichten im Bereich des zweiten Materials führt, wird minimiert.

Weiterhin ermöglicht es die erfindungsgemäße Ausgestaltung des elektronischen Bauelements, dass die Schichten zu dessen Aufbau, insbesondere die Schicht aus dem zweiten Material, sehr viel dünner ausgebildet werden können als bisher. Besonders dünne Schichten erwiesen sich nämlich bisher als Sollbruchstellen in Schichtstapeln, an welchen die strukturelle Integrität besonders gefährdet ist. Die nun eröffnete Möglichkeit, besonders dünne Schichten einzusetzen, wirkt sich insbesondere auf die Herstellungskosten für ein elektronisches Bauelement günstig aus.

Dabei hat es sich bewährt, wenn die erste Adhäsionskraft um mindestens 50 %, insbesondere um mindestens 75 % geringer ist als die zweite Adhäsionskraft. Ein solcher Unterschied zwischen erster und zweiter Adhäsionskraft lässt es als besonders vielversprechend erscheinen, die bessere Haftung des dritten Materials am ersten Material zu nutzen, um das zweite Material am ersten Material zu verankern.

Es hat sich bewährt, wenn das erste Material die Oberfläche des Substrats bildet, das zweite Material durch eine auf der Oberfläche des Substrats angeordnete erste Schicht bereitgestellt ist und das dritte Material durch eine auf der Oberfläche der ersten Schicht angeordnete zweite Schicht bereitgestellt ist.

Genauso vorteilhaft ist es aber, wenn das erste, das zweite und das dritte Material durch drei dünne Schichten des Schichtstapels bereitgestellt sind. Diese können dabei direkt an das Substrat angrenzen oder davon beabstandet angeordnet sein.

Selbstverständlich kann die Erfindung auch mehrere Bereiche des elektronischen Bauelements gleichzeitig betreffen. So kann beispielsweise ein schichtförmiges drittes Material beidseitig mit einem schichtförmigen zweiten Material bedeckt sein, wobei das dritte Material das zweite Material auf einer Seite an einem Substrat verankert und auf der anderen Seite an einer weiteren Schicht aus einem ersten Material verankert. Diverse Ausbildungen sind hierbei für den Fachmann ersichtlich, ohne den Gegenstand der Erfindung zu verlassen.

Insbesondere weisen die dünnen Schichten des Schichtstapels jeweils eine Schichtdicke im Bereich von 1nm bis 10µm, vorzugsweise im Bereich von 1nm bis 1µm, auf. Für halbleitende Schichten ist dabei eine Schichtdicke im Bereich von 1nm bis 300nm bevorzugt. Elektrisch isolierende Schichten oder Schutzschichten werden bevorzugt mit einer Schichtdicke im Bereich von 5nm bis 1µm ausgebildet, während elektrisch leitfähige Schichten vorzugsweise mit einer Schichtdicke im Bereich von 1nm bis 100nm ausgebildet werden. Derartige Schichtdicken ermöglichen eine optimale Verankerung des zweiten Materials am ersten Material im Bereich der mindestens einen Öffnung.

Weiterhin kann das flexible Substrat mehrlagig ausgebildet sein. So werden unter anderem Substrate aus unterschiedlichen, üblicherweise im Hinblick auf den Verarbeitungsprozess miteinander ausreichend fest verbundenen Materiallagen eingesetzt, wobei lediglich die an den Schichtstapel angrenzende Oberfläche des Substrats im Hinblick auf die Adhäsion der darauf aufgebrachten Schichten von Interesse ist.

So kann das Substrat je nach den gewünschten Eigenschaften beispielsweise Papier-, Kunststoff-, Metall-, Gewebeschichten oder anorganische-Schichten aufweisen. Vorzugsweise wird das Substrat aber durch eine Folie aus PET oder PVP oder aus - gegebenenfalls Kunststoff-beschichtetem - Papier bereitgestellt.

Die Flexibilität des elektronischen Bauelements macht dieses besonders widerstandsfähig, insbesondere völlig unempfindlich gegen Stoßbelastungen. Im Gegensatz zu auf starren Substraten aufgebauten Bauelementen sind solche mit flexiblen Substraten einsetzbar in Applikationen, bei denen sich das elektronische Bauelement an Objekte mit unregelmäßiger Kontur, beispielsweise Verpackungen, anschmiegen soll. Diese sind mit wachsender Tendenz für Geräte mit unregelmäßig ausgebildeten Konturen, wie Handys oder elektronische Kameras, vorgesehen.

Besonders bevorzugt ist es, wenn das zweite Material die mindestens eine Öffnung an mindestens 50% des Öffnungsumfangs, insbesondere an 100% des Öffnungsumfangs, begrenzt. So kann eine Öffnung im schichtförmigen zweiten Material beispielsweise im Randbereich oder innerhalb der Schicht angeordnet werden. Öffnungen im Bereich der Schichtecke oder Schichtkante führen zu einer Verlängerung des Umfangs der Schicht aus zweitem Material und damit zu einer verbesserten Verankerung dieser mittels des schichtförmigen dritten , Materials am ersten Material. Öffnungen in der Schicht aus zweitem Material, die entfernt vom Rand, also senkrecht zum Substrat gesehen allseitig von zweitem Material umgeben angeordnet werden, sind bei Schichten aus zweitem Material besonders bevorzugt, die zumindest bereichsweise so breit ausgebildet sind, dass die Gefahr einer flächigen Ablösung/Aufwölbung im Mittenbereich besteht. Eine Öffnung, die zu 100% ihres Umfangs von zweitem Material begrenzt ist, vermindert die Breite der Schicht aus zweitem Material in diesem Bereich und ermöglicht eine Verbindung zwischen dem dritten Material und dem ersten Material durch die Schicht aus zweitem Material hindurch. Dies erhöht die Flexibilität und Haftung zwischen dem zweiten und dem ersten Material und vermindert die Gefahr einer Ablösung im Mittenbereich der Schicht aus zweitem Material. Eine Anordnung von Öffnungen im Randbereich und im Mittenbereich der Schicht aus zweitem Material ist besonders bevorzugt.

Es hat sich weiterhin bewährt, wenn die mindestens eine Öffnung an ihrem maximalen Querschnitt, senkrecht zur Oberfläche des Substrats gesehen, eine Breite im Bereich von 0,5 bis 200 µm, insbesondere im Bereich von 0,5 bis 2,5 µm aufweist. Derart ausgestaltete Öffnungen ermöglichen einen ausreichenden Kontakt zwischen dem schichtförmigen dritten Material und dem ersten Material. Öffnungen mit kleineren Durchmessern behindern das dritte Material eher, in Kontakt zum ersten Material zu treten, so dass es zu keiner ausreichenden Verankerung kommt, während größere Öffnungsdurchmesser die Funktionalität der Schicht aus zweitem Material wesentlich beeinträchtigen können.

Insgesamt hat es sich bewährt, wenn etwa 5 bis 50%, insbesondere 5 bis 10%, der Fläche des zweiten Materials mit Öffnungen belegt ist. Insbesondere sollte nicht mehr als 50% einer für die elektrischen Werte des Bauelement kritischen Dimension des zweiten Materials durch Öffnungen unterbrochen sein, um die Funktionsfähigkeit des Bauelements nicht zu beeinträchtigen.

Generell können unterschiedlichste Öffnungsquerschnitte, beispielsweise in Kreis-, Ellipsen-, Quadrat-, Rechteck-, Dreieck-, Sternform oder freier Form sowie Kombination dieser Formen, ausgebildet werden.

Vorzugsweise weist das zweite Material eine Schichtdicke im Bereich von 1 bis 200 nm auf. Schichtförmige zweite Materialien mit derartigen Schichtdicken ermöglichen einen ausreichenden Kontakt zwischen dem schichtförmigen dritten Material und dem ersten Material. Dickere Schichten aus zweitem Material behindern die Verankerung des dritten Materials am ersten Material, so dass das zweite Material nicht ausreichend verankert wird.

Weiterhin hat es sich als günstig erwiesen, wenn eine Schichtdicke des dritten Materials mindestens 10% der Schichtdicke des zweiten Materials beträgt. So wird gewährleistet, dass die Schicht aus drittem Material eine geschlossene Schicht bildet und nicht im Bereich der mindestens einen Öffnung unterbrochen ist Dünnere Schichten aus drittem Material behindern die Verankerung des dritten Materials am ersten Material, so dass das zweite Material nicht ausreichend verankert wird.

Insbesondere ist es bevorzugt, wenn das schichtförmige zweite Material senkrecht zur Oberfläche des Substrats gesehen etwa bis zu 50% der Gesamtfläche mit Öffnungen versehen ist. Eine geeignete Einstellung der Breite der zwischen den Öffnungen und am Rand verbleibenden Stege aus zweitem Material wird dabei über eine gleichmäßige Anordnung von Öffnungen bewirkt, so dass das bereits oben erwähnte Ablösen und gegebenenfalls Aufwölben von breiten Schichten aus zweitem Material in deren Mittenbereich unterbunden wird.

Dabei hat es sich bewährt, wenn das zweite Material senkrecht zur Oberfläche des Substrats gesehen an jeder Stelle eine Breite aufweist, die um weniger als etwa 25% von der Breite des zweiten Materials in den übrigen Bereichen abweicht. Je gleichmäßiger dabei die Stegbreiten der Schicht aus zweitem Material ausgebildet werden, desto gleichmäßiger ist auch die erzielte Verbesserung der Haftung des zweiten Materials am ersten Material.

Vorzugsweise ist das zweite Material elektrisch leitfähig, insbesondere aus einem Metall, einem leitfähigen Polymer, einem leitfähigen Kleber, einer leitfähigen Substanz mit leitfähigen anorganischen Partikeln in einer Polymermatrix oder aus einer Paste/Tinte enthaltend elektrisch leitfähige Partikel gebildet. Als Metall kommen dabei beispielsweise Gold, Silber Titan, Kupfer oder Legierungen aus diesen in Frage. Als leitfähige Polymere haben sich unter anderem Polyanilin oder Polyethylendioxythiophen (PeDOT) bewährt, während als Pasten/Tinten enthaltend elektrisch leitfähige Partikel oft solche mit Silber- oder Graphit/Ruß-Partikeln eingesetzt werden.

Besonders bevorzugt ist es dabei, wenn das zweite Material als eine erste Elektrode fungiert. Dabei sind unter einer ersten Elektrode auch Elektrodenpaare, beispielsweise die auf gleicher Ebene auf dem Substrat angeordneten Source- und Drain-Elektroden eines p-leitenden Feldeffekttransistors, zu verstehen.

Besonders bevorzugt ist es dabei, wenn das Bauelement weiterhin eine zweite Elektrode aufweist, welche ebenfalls Öffnungen zur Erhöhung ihrer Flexibilität aufweist. Die Öffnungen in der zweiten Elektrode werden dabei analog zu den Öffnungen in der ersten Elektrode gebildet, was soviel bedeutet, als auch hier die Anzahl, Anordnung und der Öffnungsquerschnitt so gebildet werden, als würde es sich um eine Öffnung im schichtförmigen zweiten Material handeln.

Dabei können die Öffnungen in der zweiten Elektrode deckungsgleich zu den Öffnungen in der ersten Elektrode ausgebildet sein, insbesondere bei gleichen Flächen-Dimensionen von erster und zweiter Elektrode, oder in Art, Anzahl und Lage abweichen, insbesondere bei abweichenden Flächen-Dimensionen von erster und zweiter Elektrode.

Weiterhin ist es möglich, dass das zweite Material mehrschichtig ausgebildet ist, insbesondere aus mehreren Metallschichten und/oder mehreren Polymerschichten und/oder mehreren Pasten/Tinten-Schichten oder ähnlichem. Entscheidend ist hierbei die Adhäsionskraft der an das erste Material angrenzenden Einzelschicht aus zweitem Material bzw. der Adhäsionskraft der an das erste Material angrenzenden Einzelschicht aus drittem Material.

Es ist bevorzugt, wenn das dritte Material die elektrische Funktionsschicht aus elektrisch leitendem oder halbleitendem Material bildet. Die Bildung der halbleitenden elektrischen Funktionsschicht kann vorzugsweise mittels verdruckbaren, löslichen anorganischen Halbleitern oder Polymeren erfolgen, wobei der Begriff des Polymers hier ausdrücklich polymeres Material und/oder oligomeres Material und/oder Material aus "small molecules" und/oder Material aus Nanopartikeln einschließt. Nanopartikel bestehen aus metallorganischen halbleiterorganischen Verbindungen, die beispielsweise Zinkoxid als nicht organischen Bestandteil enthalten. Es kann sich bei dem Polymer um einen hybriden Werkstoff handeln, beispielsweise um einen n-leitenden polymeren Halbleiter auszubilden. Es sind auch beispielsweise Silikone eingeschlossen. Weiterhin soll der Begriff nicht im Hinblick auf die Molekülgröße beschränkt sein, sondern wie weiter oben ausgeführt, "small molecules" oder "Nanopartikel" einschließen. Es kann vorgesehen sein, dass die Halbleiterschichten mit unterschiedlichem organischen Material ausgebildet sind.

Die Halbleiterschicht kann als p-Leiter oder als n-Leiter ausgebildet sein. Die Stromleitung in einem p-Leiter erfolgt fast ausschließlich durch Defektelektronen, die Stromleitung in einem n-Leiter fast ausschließlich durch Elektronen. Die jeweils vorherrschend vorhandenen Ladungsträger werden als Majoritätsträger bezeichnet. Wenngleich die p-Dotierung für organische Halbleiter typisch ist, ist es doch möglich, das Material mit n-Dotierung auszubilden. Als p-leitende Halbleiter können Pentacen, Polyalkylthiophen etc. vorgesehen sein, als n-leitende Halbleiter z. B. lösliche Fulleren-Derivate.

Weiterhin hat es sich als vorteilhaft erwiesen, wenn das dritte Material die elektrische Funktionsschicht aus elektrisch leitendem oder halbleitendem Material bildet, wobei klassische Halbleiter (kristallines Silizium oder Germanium) und typische metallischen Leiter verwendet werden.

Vorzugsweise weist das schichtförmige zweite Material mindestens zwei Öffnungen auf, wobei die mindestens zwei Öffnungen senkrecht zur Oberfläche des Substrats gesehen den gleichen Querschnitt aufweisen. Diese Ausgestaltung der Öffnungen bietet sich insbesondere dann an, wenn die Schicht aus zweitem Material eine einfache geometrische Form aufweist, beispielsweise rechteckig, quadratisch, rund oder ähnlich ausgebildet ist.

Es ist aber ebenso möglich, dass das zweite Material mindestens zwei Öffnungen aufweist, wobei die mindestens zwei Öffnungen senkrecht zur Oberfläche des Substrats gesehen mindestens einen unterschiedlichen Querschnitt aufweisen. Eine derartige Ausgestaltung der Öffnungen erweist sich insbesondere dann als vorteilhaft, wenn die Schicht aus zweitem Material eine komplexere geometrische Form mit Abwinkelungen aufweist, beispielsweise T-förmig oder sternförmig ausgebildet ist.

Es hat sich als vorteilhaft erwiesen, wenn das elektronische Bauelement als ein organisches Halbleiterbauelement, insbesondere ein Feldeffekt-Transistor (OFET), als eine organische Diode, als ein organischer Kondensator mit spannungsgesteuerter Kapazität, als ein organischer Widerstand oder als eine organische elektrische Leitungsanordnung ausgebildet ist.

Bei einem organischen Feldeffekt-Transistor (OFET) handelt es sich um einen Feldeffekt-Transistor mit mindestens drei Elektroden, einer Halbleiterschicht und einer Isolierschicht. Der OFET ist auf einem Trägersubstrat angeordnet. Eine Schicht aus einem organischen, halbleitenden Material bildet einen leitfähigen Kanal, dessen Endabschnitte durch eine Source-Elektrode und eine Drain-Elektrode gebildet sind. Der leitfähige Kanal ist mit einer Isolationsschicht abgedeckt, auf der eine Gate-Elektrode angeordnet ist. Durch Anlegen einer Gate-Source-Spannung U_{GS} zwischen Gate-Elektrode und Source-Elektrode kann die Leitfähigkeit des Kanals verändert werden. Die Ladungsträger werden durch die Ausbildung eines elektrischen Feldes in der Isolationsschicht verdichtet, wenn eine Gate-Source-Spannung U_{GS} geeigneter Polarität angelegt wird, d.h. bei p-Leitern eine negative Spannung bzw. bei n-Leitern eine positive Spannung. Infolgedessen sinkt der elektrische Widerstand zwischen der Drain-Elektrode und der Source-Elektrode. Es kann sich nun bei Anlegen einer Drain-Source-Spannung U_{DS} ein größerer Stromfluss zwischen der Source- und der Drain-Elektrode ausbilden, als bei einer offenen Gate-Elektrode. Es handelt sich bei einem Feldeffekttransistor also um einen gesteuerten Widerstand.

Insbesondere ist für das elektronische Bauelement bevorzugt, wenn die elektrische Funktionsschicht aus einem elektrisch leitenden oder halbleitenden Material mittels einer Flüssigkeit, insbesondere durch ein Druckverfahren, gebildet ist. Der Begriff Flüssigkeit umfasst dabei beispielsweise Suspensionen, Emulsionen, sonstige Dispersionen oder auch Lösungen. Das Druckverhalten der Flüssigkeit wird dabei durch Parameter wie Viskosität, Konzentration, Siedetemperatur und Oberflächenspannung bestimmt. So kann eine Variation der Dicke der durch Drucken gebildeten elektrischen Funktionsschicht dadurch erreicht werden, dass entweder die Konzentration an organischem Material, beispielsweise Polymer, in der Flüssigkeit erhöht wird oder die Auftragsmenge in einem Druckvorgang erhöht wird oder die Anzahl an Flüssigkeitsaufträgen mit Zwischentrocknung erhöht wird. Als Druckverfahren sind hierbei Tiefdruck, Hockdruck, Siebdruck, Flexo- oder Tampondruck, Schablonendruck oder ähnliches verwendbar. Auch einem Druckverfahren gleichzusetzende Verfahren wie ein Aufrakeln ist möglich.

Weiterhin ist es für das elektronische Bauelement bevorzugt, wenn die elektrische Funktionsschicht aus einem elektrisch leitenden oder halbleitenden Material durch Abscheidung über eine Gasphase, insbesondere durch Aufdampfen oder Sputtern, gebildet ist.

Es hat sich für das elektronische Bauelement bewährt, wenn dass die elektrische Funktionsschicht aus einem elektrisch leitenden oder halbleitenden Material mittels Laser oder Photolithographie strukturiert ist.

Vorzugsweise ist die elektrische Funktionsschicht aus einem elektrisch leitenden oder halbleitenden Material in einem kontinuierlichen Herstellungsverfahren gebildet. Hier sind Rolle-zu-Rolle-Verfahren besonders bevorzugt.

Die Figuren 1a bis 5c sollen die Erfindung beispielhaft erläutern. So zeigt/zeigen
- Figur 1a: einen Querschnitt durch ein Substrat mit zwei darauf angeordneten Schichten,
- Figur 1b: eine Draufsicht auf die Schicht 2 aus Figur 1a,
- Figur 2a: einen Querschnitt durch ein Substrat mit drei darauf angeordneten Schichten,
- Figuren 2b und 2c: jeweils eine Draufsicht auf eine mögliche Variante der Schicht 2 aus Figur 2a,
- Figur 3a: einen Querschnitt durch ein weiteres Substrat mit drei darauf angeordneten Schichten,
- Figuren 3b und 3c: jeweils eine Draufsicht auf eine mögliche Variante der Schicht 2 aus Figur 3a,
- Figur 4a: einen Querschnitt durch einen OFET,
- Figuren 4b und 4c: jeweils eine Draufsicht auf eine mögliche Variante der Schicht 2a aus Figur 4a,
- Figur 5a: einen Querschnitt durch einen Kondensator mit spannungsgesteuerter Kapazität und
- Figuren 5b und 5c: jeweils eine Draufsicht auf eine mögliche Variante der Schicht 2a aus Figur 5a.

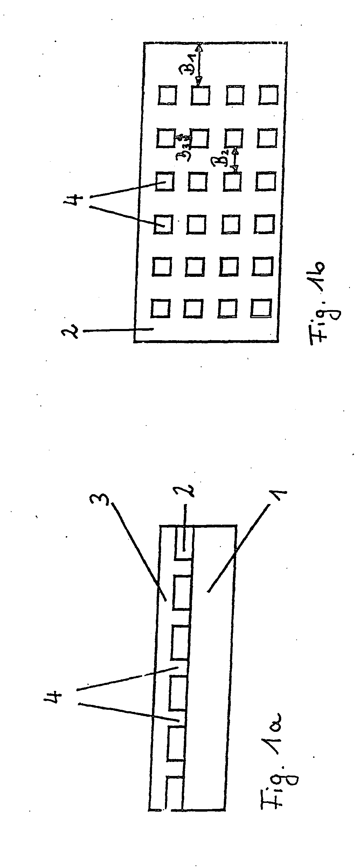

Figur 1a zeigt einen Querschnitt durch ein flexibles Substrat 1 in Form einer Kunststoff-Folie aus einem ersten Material, hier aus PET, Auf dem Substrat 1 ist eine erste Schicht aus einem zweiten Material 2 mit einer Schichtdicke von 10nm angeordnet, wobei als zweites Material 2 aufgesputtertes Silber eingesetzt wurde. Die erste Schicht aus dem zweiten Material 2 weist Öffnungen 4 auf (siehe auch Figur 1b). Über der ersten Schicht aus dem zweiten Material 2 ist eine zweite Schicht aus einem dritten Material 3 angeordnet, wobei die zweite Schicht aus dem dritten Material 3 eine Schichtdicke von 20nm aufweist und durch die Öffnungen 4 hindurch in Kontakt zum Substrat 1 aus dem ersten Material steht. Zur Bildung der, zweiten Schicht aus dem dritten Material 3 wurde hierbei eine Flüssigkeit enthaltend Poly-3-alkylthiopen aufgedruckt und getrocknet. Eine zweite Adhäsionskraft des dritten Materials 2 am ersten Material, welches durch die Oberfläche des Substrats 1 bereitgestellt wird, ist dabei höher als eine erste Adhäsionskraft des zweiten Materials 2 am ersten Material.

Figur 1b zeigt eine Draufsicht auf die erste Schicht aus dem zweiten Material 2 aus Figur 1a. Dabei ist erkennbar, dass es sich bei den Öffnungen 4 im zweiten Material 2 um quadratische Öffnungen mit gleichem Öffnungsquerschnitt handelt. Die Seitenlänge der Öffnungen beträgt 10µm. Die Menge an Öffnungen 4, sowie deren Anzahl und Anordnung ist so gewählt, dass weniger als 50% der Gesamtfläche der ersten Schicht aus dem zweiten Material 2 ausgespart ist. Die Breite (siehe beispielhaft die Breiten B₁, B₂ und B₃ in Figur 1b) des zweiten Materials 2, die senkrecht zum Substrat gesehen verbleibt, ist kleiner als 30µm. Dies gewährleistet eine zuverlässige und gleichmäßige Fixierung des zweiten Materials 2 mittels der zweiten Schicht aus dem dritten Material 3 am ersten Material beziehungsweise der Substratoberfläche.

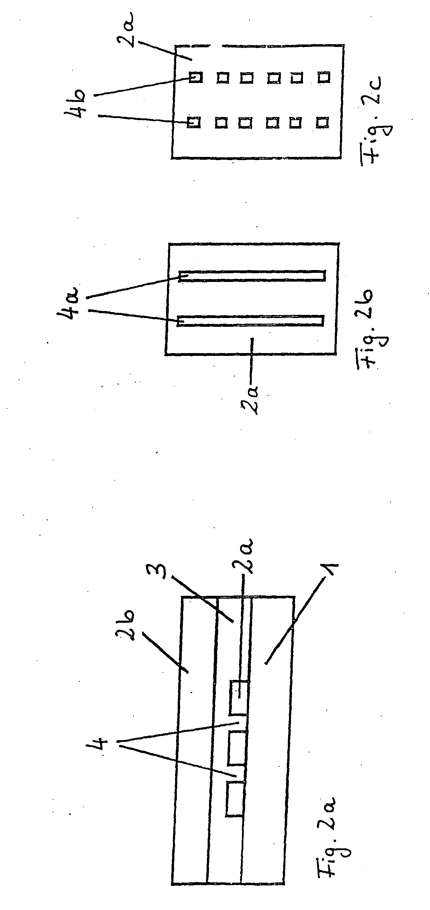

Figur 2a zeigt einen Querschnitt durch ein flexibles Substrat 1 aus PET als erstem Material; auf welchem eine erste Schicht aus einem zweiten Material 2a angeordnet ist. Die Schicht aus dem zweiten Material 2a ist aus Silberleitpaste in einer Schichtdicke von 15 nm gebildet worden und weist Öffnungen 4 auf. Auf der Schicht aus dem zweiten Material 2a ist eine zweite Schicht aus einem dritten Material 3 angeordnet, welches eine Schichtdicke von 35 nm aufweist und durch die Öffnungen 4 hindurch in direktem Kontakt zu der Oberfläche des Substrats 1 beziehungsweise zum ersten Material steht. Auf der zweiten Schicht aus dem dritten Material 3 ist eine mittels Silberleitpaste gebildete, flächige Elektrode 2b angeordnet. Um die Flexibilität der Elektrode 2b zu erhöhen, wird diese vorzugsweise ebenfalls mit Öffnungen gemäß der ersten Schicht aus dem zweiten Material 2a versehen (hier nicht dargestellt). Das dritte Material 3 ist aus dem organisch halbleitenden Material Pentacen gebildet, wobei die Adhäsionskraft des dritten Materials 3 am Substrat 1 höher ist als die Adhäsionskraft des zweiten Materials am Substrat 1.

Die Figuren 2b und 2c zeigen jeweils eine Draufsicht auf eine mögliche Variante der ersten Schicht aus Figur 2a, wobei die Figur 2b zwei gleich große, rechteckige Öffnungen 4a und die Figur 2c mehrere gleich große, quadratische Öffnungen 4b aufzeigt, die als Öffnungen 4 gemäß Figur 2a eingesetzt werden können. Dabei sind die Öffnungsquerschnitte der Öffnungen 4a, 4b im Verhältnis zur Flächenausdehnung der ersten Schicht so klein gewählt, dass die Funktion der ersten Schicht nicht beeinträchtigt wird. Das Verhältnis zwischen der Summe der Öffnungsquerschnitte aller Öffnungen zur Fläche der ersten Schicht liegt dabei vorzugsweise im Bereiche von 1:20 bis 1:1.

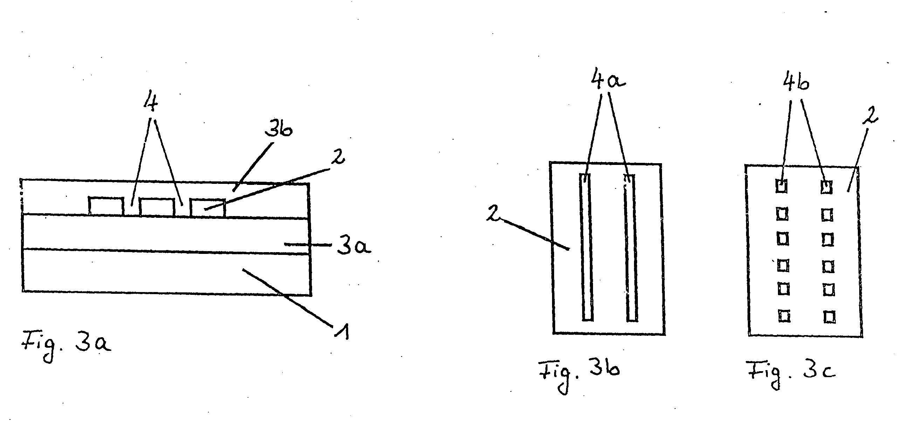

Die Figur 3a zeigt einen Querschnitt durch ein flexibles Substrat 1 aus Papier, auf welchem eine Schicht aus einem ersten Material 3a angeordnet ist. Das erste Material 3a ist dabei aus dem organischen Halbleiter Poly-3-alkylthiopen in einer Schichtdicke von 15 nm gebildet. Auf der Schicht aus dem ersten Material 3a ist eine Schicht aus einem zweiten Material 2 gebildet, die Öffnungen 4 aufweist. Das zweite Material 2 ist aus aufgedampftem Kupfer in einer Schichtdicke von 10 nm gebildet. Auf der Schicht aus dem zweiten Material 2 ist eine weitere Schicht aus einem dritten Material 3b mit einer Schichtdicke von 15 nm angeordnet, wobei das dritte Material 3b gleich dem ersten Material 3a gewählt ist. Somit ergibt sich zwischen den Schichten aus dem dritten Material 3b und dem ersten Material 3a eine höhere Adhäsionskraft als zwischen der Schicht aus dem zweiten Material 2 und der Schicht aus dem ersten Material 3a.

Die Figuren 3b und 3c zeigen jeweils eine Draufsicht auf eine mögliche Variante der Schicht 2 aus Figur 3a, wobei die Figur 3b zwei gleich große, rechteckige Öffnungen 4a und die Figur 3c mehrere gleich große, quadratische Öffnungen 4b aufzeigt, die als Öffnungen 4 gemäß Figur 3a eingesetzt werden können.

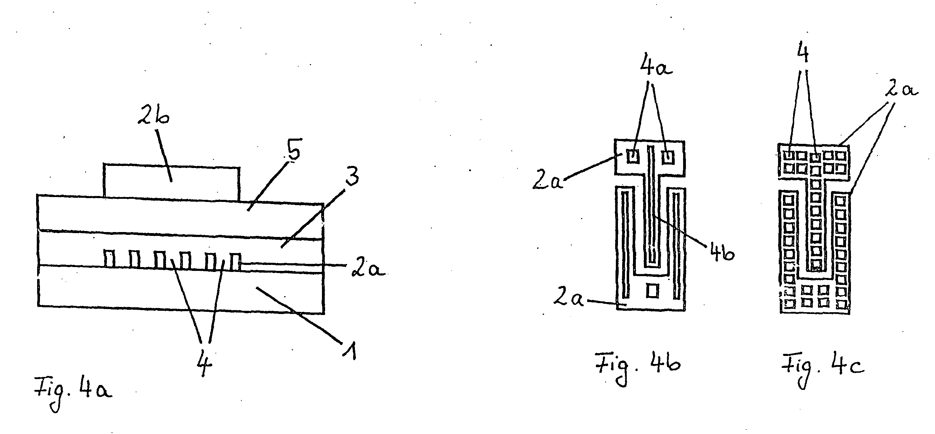

Figur 4a zeigt einen Querschnitt durch einen OFET mit einem flexiblen Substrat 1 aus PVP (=erstes Material), einer ersten Schicht aus einem zweiten Material 2a, hier aufgedampftes Gold in einer Schichtdicke von 12 nm, wobei die erste Schicht die Source-/Drain-Elektroden des OFET bereitstellt, sowie einer zweiten Schicht aus einem dritten Material 3, welches organisch halbleitend, hier aus Poly-3-alkylthiophen gebildet ist. Auf der zweiten Schicht aus dem dritten Material 3, die eine Schichtdicke von 23 nm aufweist, befindet sich eine organische, elektrisch isolierende Schicht 5, welche wiederum eine Gate-Elektrode 2b aus aufgedampftem Gold trägt.
Die erste Schicht aus dem zweiten Material 2a weist Öffnungen 4 auf, durch welche hindurch die zweite Schicht aus dem dritten Material 3 in Kontakt zum ersten Material beziehungsweise zur Oberfläche des Substrats 1 steht. Dadurch wird eine gute Haftung der ersten Schicht aus dem zweiten Material 2 am ersten Material erreicht.
Um die Flexibilität und Haftung der Elektrode 2b zu erhöhen, wird diese vorzugsweise ebenfalls mit Öffnungen ähnlich denen in der ersten Schicht aus dem zweiten Material 2a versehen (hier nicht dargestellt).

Die Figuren 4b und 4c zeigen jeweils eine Draufsicht auf eine mögliche Variante der Schicht 2a aus Figur 4a. In Figur 4b sind dabei Öffnungen 4a, 4b mit unterschiedlichem Öffnungsquerschnitt vorgesehen, während in Figur 4c lediglich Öffnungen 4 mit gleichem Öffnungsquerschnitt angeordnet sind.

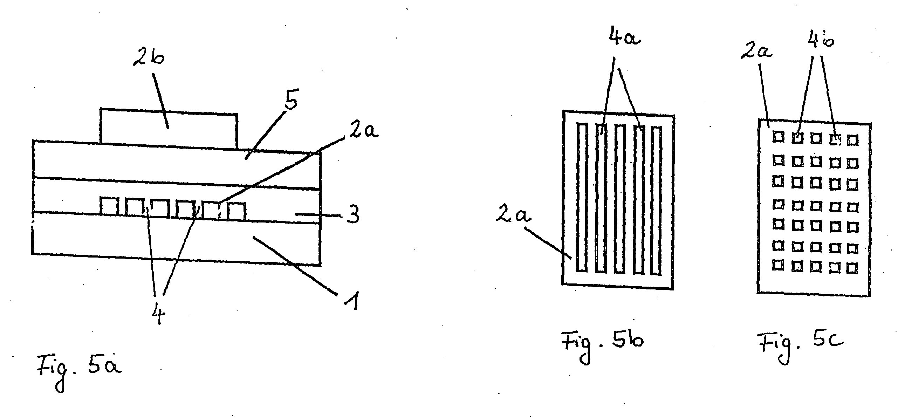

Figur 5a zeigt einen Querschnitt durch einen Kondensator mit spannungsgesteuerter Kapazität, welcher ein Substrat 1 aus einem ersten Material aufweist. Das erste Material ist aus PET-Folie gebildet. Auf dem Substrat 1 ist eine erste Schicht aus einem zweiten Material 2a angeordnet. Das zweite Material 2a ist aus PeDOT mit einer Schichtdicke von 1nm gebildet und weist Öffnungen 4 auf. Auf der Schicht aus dem zweiten Material 2a ist eine zweite Schicht aus einem dritten Material 3 angeordnet, welches aus dem organischen Halbleiter Poly-3-alkylthiophen gebildet ist. Die zweite Schicht aus einem dritten Material 3 ist über die Öffnungen 4 in der ersten Schicht mit dem Substrat 1 verbunden und fixiert dadurch die erste Schicht zuverlässig am Substrat 1. Auf der zweiten Schicht ist eine elektrisch isolierende Schicht 5 aus Polyhydroxystyrol (PHS) angeordnet. Auf der Schicht 5 ist eine elektrisch leitende Schicht 2b, welche als Elektrode fungiert und aus PeDOT gebildet ist, angeordnet.
Um die Flexibilität und damit die Haftung der Elektrode 2b zu erhöhen, wird diese vorzugsweise ebenfalls mit Öffnungen wie denen in der ersten Schicht aus dem zweiten Material 2a versehen (hier nicht dargestellt).

Die Figuren 5b und 5c zeigen jeweils eine Draufsicht auf eine mögliche Variante der Schicht aus dem zweiten Material 2a aus Figur 5a. In Figur 5b sind dabei Öffnungen 4a mit rechteckigem Öffnungsquerschnitt vorgesehen, während in Figur 5c in der Schicht aus dem zweiten Material 2a Öffnungen 4b mit quadratischem Öffnungsquerschnitt angeordnet sind, um die Flexibilität der ersten Schicht und deren Haftung am Substrat 1 zu verbessern.

## Patentansprüche

1. Elektronisches Bauelement mit einem flexiblen Substrat (1), auf dessen Oberfläche ein Schichtstapel aus dünnen Schichten, enthaltend mindestens eine gedruckte organische elektrische Funktionsschicht aus einem elektrisch leitenden oder halbleitenden Material, angeordnet ist, wobei das Bauelement mindestens ein erstes Material (3a), ein schichtförmiges zweites Material (2, 2a) und ein schichtförmiges drittes Material (3, 3b) umfasst und wobei senkrecht zur Oberfläche des Substrats (1) gesehen auf das erste Material (3a) das zweite Material (2, 2a) folgt und auf das zweite Material (2, 2a) das dritte Material (3, 3b) folgt, wobei
eine erste Adhäsionskraft des zweiten Materials (2, 2a) am ersten Material (3a) geringer ist als eine zweite Adhäsionskraft des dritten Materials (3, 3b) am ersten Material (3a) und dass das zweite Material (2, 2a) mindestens eine Öffnung (4, 4a, 4b) aufweist, über welche das dritte Material (3, 3b) mit dem ersten Material (3a) zur Erhöhung der Haftung des zweiten Materials (2, 2a) am ersten Material (3a) verbunden ist.

2. Elektronisches Bauelement nach Anspruch 1,
**dadurch gekennzeichnet,**
**dass** die erste Adhäsionskraft um mindestens 50 %, insbesondere um mindestens 75 % geringer ist als die zweite Adhäsionskraft.

3. Elektronisches Bauelement nach einem der Ansprüche 1 oder 2,
**dadurch gekennzeichnet,**
**dass** das erste Material die Oberfläche des Substrats (1) bildet, dass das zweite Material (2, 2a) durch eine auf der Oberfläche des Substrats (1) angeordnete erste Schicht bereitgestellt ist und dass das dritte Material (3, 3b) durch eine auf der Oberfläche der ersten Schicht angeordnete zweite Schicht bereitgestellt ist.

4. Elektronisches Bauelement nach einem der Ansprüche 1 oder 2,
**dadurch gekennzeichnet,**
**dass** das erste, das zweite und das dritte Material durch drei dünne Schichten des Schichtstapels bereitgestellt sind.

5. Elektronisches Bauelement nach einem der Ansprüche 1 bis 4,
**dadurch gekennzeichnet,**
**dass** die dünnen Schichten des Schichtstapels jeweils eine Schichtdicke im Bereich von 1nm bis 10µm aufweisen.

6. Elektronisches Bauelement nach einem der Ansprüche 1 bis 5,
**dadurch gekennzeichnet,**
**dass** das flexible Substrat (1) durch eine Folie aus PET oder PVP gebildet ist.

7. Elektronisches Bauelement nach einem der Ansprüche 1 bis 5,
**dadurch gekennzeichnet,**
**dass** das flexible Substrat (1) mehrlagig ausgebildet ist.

8. Elektronisches Bauelement nach einem der Ansprüche 1 bis 7,
**dadurch gekennzeichnet,**
**dass** das schichtförmige zweite Material (2, 2a) die mindestens eine Öffnung (4, 4a, 4b) an mindestens 50% des Öffnungsumfangs begrenzt.

9. Elektronisches Bauelement nach Anspruch 8,
**dadurch gekennzeichnet,**
**dass** das schichtförmige zweite Material (2, 2a) die mindestens eine Öffnung (4, 4a, 4b) an 100% des Öffnungsumfangs begrenzt.

10. Elektronisches Bauelement nach Anspruch 8,
**dadurch gekennzeichnet,**
**dass** die mindestens eine Öffnung im Randbereich des schichtförmigen zweiten Materials (2, 2a) angeordnet ist und eine Verlängerung des Umfangs des schichtförmigen zweiten Materials (2, 2a) bewirkt.

11. Elektronisches Bauelement nach Anspruch 9 und Anspruch 10,
**dadurch gekennzeichnet,**
**dass** mindestens eine Öffnung (4, 4a, 4b) innerhalb des schichtförmigen zweiten Materials (2, 2a) und mindestens eine weitere Öffnung im Randbereich des schichtförmigen zweiten Materials (2, 2a) angeordnet ist.

12. Elektronisches Bauelement nach einem der Ansprüche 1 bis 11,
**dadurch gekennzeichnet,**
**dass** die mindestens eine Öffnung (4, 4a, 4b) an ihrem maximalen Querschnitt, senkrecht zur Oberfläche des Substrats (1) gesehen, eine Breite im Bereich von 0,5 bis 200 µm, insbesondere im Bereich von 0,5 bis 2,5 µm, aufweist.

13. Elektronisches Bauelement nach einem der Ansprüche 1 bis 12,
**dadurch gekennzeichnet,**
**dass** das zweite Material (2, 2a) eine Schichtdicke im Bereich von 1 bis 200 nm aufweist.

14. Elektronisches Bauelement nach einem der Ansprüche 1 bis 13,
**dadurch gekennzeichnet,**
**dass** das dritte Material (3, 3b) eine Schichtdicke aufweist, die mindestens 10 % der Schichtdicke des zweiten Materials (2, 2a) beträgt.

15. Elektronisches Bauelement nach einem der Ansprüche 1 bis 14,
**dadurch gekennzeichnet,**
**dass** 5 bis 50 %, insbesondere 5 bis 10 %, einer Gesamtfläche des zweiten Materials mit Öffnungen belegt ist.

16. Elektronisches Bauelement nach einem der Ansprüche 1 bis 15,
**dadurch gekennzeichnet,**
**dass** das zweite Material (2, 2a) senkrecht zur Oberfläche des Substrats (1) gesehen an jeder Stelle eine Breite aufweist, die um weniger als 25 % von der Breite des zweiten Materials (2, 2a) in den übrigen Bereichen abweicht.

17. Elektronisches Bauelement nach einem der Ansprüche 1 bis 16,
**dadurch gekennzeichnet,**
**dass** das zweite Material (2, 2a) elektrisch leitfähig ist, insbesondere aus einem Metall, einem leitfähigen Polymer, einem leitfähigen Kleber, einer leitfähigen Substanz mit leitfähigen anorganischen Partikeln in einer Polymermatrix oder aus einer Paste/Tinte enthaltend elektrisch leitfähige Partikel gebildet ist.

18. Elektronisches Bauelement nach Anspruch 17,
**dadurch, gekennzeichnet,**
**dass** das zweite Material (2, 2a) als eine erste Elektrode fungiert.

19. Elektronisches Bauelement nach Anspruch 18,
**dadurch gekennzeichnet,**
**dass** das Bauelement weiterhin eine zweite Elektrode aufweist, welche ebenfalls Öffnungen zur Erhöhung ihrer Flexibilität aufweist.

20. Elektronisches Bauelement nach einem der Ansprüche 1 bis 19,
**dadurch gekennzeichnet,**
**dass** senkrecht zur Oberfläche des Substrats (1) gesehen auf das schichtförmige dritte Material (3, 3b) ein weiteres schichtförmiges zweites Material folgt, dass auf das weitere zweite Material eine weitere Schicht folgt, wobei das weitere zweite Material ebenfalls mindestens eine Öffnung aufweist, über welche das dritte Material (3, 3b) mit der weiteren Schicht zur Erhöhung der Haftung des weiteren zweiten Materials an der weiteren Schicht verbunden ist.

21. Elektronisches Bauelement nach einem der Ansprüche 17 oder 18,
**dadurch gekennzeichnet,**
**dass** das zweite Material (2, 2a) mehrschichtig ausgebildet ist, insbesondere aus mehreren Metallschichten und/oder mehreren Polymerschichten und/oder mehreren Pasten/Tinten-Schichten.

22. Elektronisches Bauelement nach einem der Ansprüche 1 bis 21,
**dadurch gekennzeichnet,**
**dass** das dritte Material (3, 3b) die gedruckte organische elektrische Funktionsschicht aus elektrisch leitendem oder halbleitendem Material bildet.

23. Elektronisches Bauelement nach einem der Ansprüche 1 bis 22,
**dadurch gekennzeichnet,**
**dass** das zweite Material (2, 2a) mindestens zwei Öffnungen (4, 4a, 4b) aufweist, wobei die mindestens zwei Öffnungen (4, 4a, 4b) senkrecht zur Oberfläche des Substrats (1) gesehen den gleichen Querschnitt aufweisen.

24. Elektronisches Bauelement nach einem der Ansprüche 1 bis 22,
**dadurch gekennzeichnet,**
**dass** das zweite Material (2, 2a) mindestens zwei Öffnungen (4, 4a, 4b) aufweist, wobei die mindestens zwei Öffnungen (4, 4a, 4b) senkrecht zur Oberfläche des Substrats (1) gesehen mindestens einen unterschiedlichen Querschnitt aufweisen.

25. Elektronisches Bauelement nach einem der Ansprüche 1 bis 24,
**dadurch gekennzeichnet,**
**dass** das elektronische Bauelement als ein organisches Halbleiterbauelement, insbesondere ein Feldeffekt-Transistor (OFET), als eine organische Diode, als ein organischer Kondensator mit spannungsgesteuerter Kapazität, als ein organischer Widerstand oder als eine organische elektrische Leitungsanordnung ausgebildet ist.

26. Elektronisches Bauelement nach einem der Ansprüche 1 bis 25,
**dadurch gekennzeichnet,**
**dass** die gedruckte organische elektrische Funktionsschicht aus einem elektrisch leitenden oder halbleitenden Material mittels einer Flüssigkeit, insbesondere durch eine Suspension, Emulsion oder eine Lösung, gebildet ist.

27. Elektronisches Bauelement nach einem der Ansprüche 1 bis 26,
**dadurch gekennzeichnet,**
**dass** eine weitere elektrische Funktionsschicht aus einem elektrisch leitenden oder halbleitenden Material durch Abscheidung über eine Gasphase; insbesondere durch Aufdampfen oder Sputtern, gebildet ist.

28. Elektronisches Bauelement nach einem der Ansprüche 1 bis 27,
**dadurch gekennzeichnet,**
**dass** die elektrische Funktionsschicht aus einem elektrisch leitenden oder halbleitenden Material mittels Laser oder Photolithographie strukturiert ist.

29. Elektronisches Bauelement nach einem der Ansprüche 1 bis 28,
**dadurch gekennzeichnet,**
**dass** die elektrische Funktionsschicht aus einem elektrisch leitenden oder halbleitenden Material in einem kontinuierlichen Herstellungsverfahren gebildet ist.

## Claims

1. Electronic component having a flexible substrate (1), on the surface of which is arranged a layer stack comprising thin layers, including at least one printed organic electrical functional layer made from an electrically conducting or semiconducting material, wherein the component comprises at least a first material (3a), a second material (2, 2a) in layer form and a third material (3, 3b) in layer form, and wherein, as seen perpendicular to the surface of the substrate (1), the first material (3a) is followed by the second material (2, 2a) and the second material (2, 2a) is followed by the third material (3, 3b), wherein a first adhesion force of the second material (2, 2a) on the first material (3a) is lower than a second adhesion force of the third material (3, 3b) on the first material (3a), and that the second material (2, 2a) has at least one opening (4, 4a, 4b), via which the third material (3, 3b) is joined to the first material (3a) in order to increase the bonding of the second material (2, 2a) to the first material (3a).

2. Electronic component according to Claim 1, **characterized in that** the first adhesion force is at least 50%, in particular at least 75%, lower than the second adhesion force.

3. Electronic component according to either of Claims 1 and 2, **characterized in that** the first material forms the surface of the substrate (1), **in that** the second material (2, 2a) is provided by a first layer arranged on the surface of the substrate (1), and **in that** the third material (3, 3b) is provided by a second layer arranged on the surface of the first layer.

4. Electronic component according to either of Claims 1 and 2, **characterized in that** the first, the second and the third materials are provided by three thin layers of the layer stack.

5. Electronic component according to one of Claims 1 to 4, **characterized in that** the thin layers of the layer stack each have a layer thickness in the range from 1 nm to 10 µm.

6. Electronic component according to one of Claims 1 to 5, **characterized in that** the flexible substrate (1) is formed by a film of PET or PVP.

7. Electronic component according to one of Claims 1 to 5, **characterized in that** the flexible substrate (1) is composed of multiple individual layers.

8. Electronic component according to one of Claims 1 to 7, **characterized in that** the second material (2, 2a) in layer form delimits the at least one opening (4, 4a, 4b) over at least 50% of the periphery of the opening.

9. Electronic component according to Claim 8, **characterized in that** the second material (2, 2a) in layer form delimits the at least one opening (4, 4a, 4b) over 100% of the periphery of the opening.

10. Electronic component according to Claim 8, **characterized in that** the at least one opening is arranged in the edge region of the second material (2, 2a) in layer form and lengthens the periphery of the second material (2, 2a) in layer form.

11. Electronic component according to Claim 9 and Claim 10, **characterized in that** at least one opening (4, 4a, 4b) is arranged inside the second material (2, 2a) in layer form and at least one further opening is arranged in the edge region of the second material (2, 2a) in layer form.

12. Electronic component according to one of Claims 1 to 11, **characterized in that** the at least one opening (4, 4a, 4b), at its maximum cross section, as seen perpendicular to the surface of the substrate (1), has a width in the range from 0.5 to 200 µm, in particular in the range from 0.5 to 2.5 µm.

13. Electronic component according to one of Claims 1 to 12, **characterized in that** the second material (2, 2a) has a layer thickness in the range from 1 to 200 nm.

14. Electronic component according to one of Claims 1 to 13, **characterized in that** the third material (3, 3b) has a layer thickness that amounts to at least 10% of the layer thickness of the second material (2, 2a).

15. Electronic component according to one of Claims 1 to 14, **characterized in that** 5 to 50%, in particular 5 to 10%, of the total area of the second material is occupied by openings.

16. Electronic component according to one of Claims 1 to 15, **characterized in that** the second material (2, 2a), as seen perpendicular to the surface of the substrate (1), at any location has a width which deviates by less than 25% from the width of the second material (2, 2a) in the remaining regions.

17. Electronic component according to one of Claims 1 to 16, **characterized in that** the second material (2, 2a) is electrically conductive, in particular is formed from a metal, a conductive polymer, a conductive adhesive, a conductive substance comprising conductive inorganic particles in a polymer matrix or from a paste/ink containing electrically conductive particles.

18. Electronic component according to Claim 17, **characterized in that** the second material (2, 2a) functions as a first electrode.

19. Electronic component according to Claim 18, **characterized in that** the component also has a second electrode, which likewise has openings in order to increase its flexibility.

20. Electronic component according to one of Claims 1 to 19, **characterized in that**, as seen perpendicular to the surface of the substrate (1), the third material (3, 3b) in layer form is followed by a further second material in layer form, **in that** the further second material is followed by a further layer, wherein the further second material likewise has at least one opening, via which the third material (3, 3b) is joined to the further layer in order to increase the bonding of the further second material to the further layer.

21. Electronic component according to either of Claims 17 and 18, **characterized in that** the second material (2, 2a) is of multilayer formation, in particular comprising a plurality of metal layers and/or a plurality of polymer layers and/or a plurality of paste/ink layers.

22. Electronic component according to one of Claims 1 to 21, **characterized in that** the third material (3, 3b) forms the printed organic electrical functional layer made from electrically conducting or semiconducting material.

23. Electronic component according to one of Claims 1 to 22, **characterized in that** the second material (2, 2a) has at least two openings (4, 4a, 4b), wherein the at least two openings (4, 4a, 4b) have the same cross section, as seen perpendicular to the surface of the substrate (1).

24. Electronic component according to one of Claims 1 to 22, **characterized in that** the second material (2, 2a) has at least two openings (4, 4a, 4b), wherein the at least two openings (4, 4a, 4b) have at least one different cross section, as seen perpendicular to the surface of the substrate (1).

25. Electronic component according to one of Claims 1 to 24, **characterized in that** the electronic component is designed as an organic semiconductor component, in particular a field-effect transistor (OFET), as an organic diode, as an organic capacitor with a voltage-controlled capacitance, as an organic resistor or as an organic electrical conduction arrangement.

26. Electronic component according to one of Claims 1 to 25, **characterized in that** the printed organic electrical functional layer made from an electrically conducting or semiconducting material is formed by means of a liquid, in particular by a suspension, emulsion or a solution.

27. Electronic component according to one of Claims 1 to 26, **characterized in that** a further electrical functional layer made from an electrically conducting or semiconducting material is formed by deposition via a vapour phase, in particular through physical vapour deposition or sputtering.

28. Electronic component according to one of Claims 1 to 27, **characterized in that** the electrical functional layer made from an electrically conducting or semiconducting material is patterned by means of laser or photolithography.

29. Electronic component according to one of Claims 1 to 28, **characterized in that** the electrical functional layer made from an electrically conducting or semiconducting material is formed in a continuous production process.

## Revendications

1. Composant électronique, comportant un substrat (1) flexible, sur la surface duquel est disposée un empilement de couches minces contenant au moins une couche fonctionnelle électrique organique imprimée, réalisée dans un matériau électroconducteur ou dans un matériau semi-conducteur, ledit composant comprenant au moins un premier matériau (3a), un deuxième matériau (2, 2a) en forme de couche et un troisième matériau (3, 3b) en forme de couche, et, par référence au sens perpendiculaire à la surface du substrat (1), le deuxième matériau (2, 2a) suit le premier matériau (3a) et le troisième matériau (3, 3b) suit le deuxième matériau (2, 2a), sachant qu'une première force d'adhésion du deuxième matériau (2, 2a) sur le premier matériau (3a) est plus faible qu'une deuxième force d'adhésion du troisième matériau (3, 3b) sur le premier matériau (3a), et que le deuxième matériau (2, 2a) comporte au moins une ouverture (4, 4a, 4b), par l'intermédiaire de laquelle le troisième matériau (3, 3b) est relié au premier matériau (3a) pour augmenter l'adhérence du deuxième matériau (2, 2a) sur le premier matériau (3a).

2. Composant électronique selon la revendication 1, **caractérisé en ce que** la première force d'adhésion est au moins 50 %, en particulier au moins 75 %, plus faible que la deuxième force d'adhésion.

3. Composant électronique selon la revendication 1 ou 2, **caractérisé en ce que** le premier matériau forme la surface du substrat (1), **en ce que** le deuxième matériau (2, 2a) est constitué par une première couche disposée sur la surface du substrat (1), et **en ce que** le troisième matériau (3, 3b) est constitué par une deuxième couche disposée sur la surface de la première couche.

4. Composant électronique selon la revendication 1 ou 2, **caractérisé en ce que** le premier, le deuxième et le troisième matériau sont constitués par trois couches minces de l'empilement de couches.

5. Composant électronique selon l'une quelconque des revendications 1 à 4, **caractérisé en ce que** les couches minces de l'empilement de couches ont chacune une épaisseur dans la plage de 1 nm à 10 µm.

6. Composant électronique selon l'une quelconque des revendications 1 à 5, **caractérisé en ce que** le substrat (1) flexible est formé par une feuille en PET ou PVP.

7. Composant électronique selon l'une quelconque des revendications 1 à 5, **caractérisé en ce que** le substrat (1) flexible est réalisé en plusieurs couches.

8. Composant électronique selon l'une quelconque des revendications 1 à 7, **caractérisé en ce que** le deuxième matériau (2, 2a) en forme de couche délimite ladite au moins une ouverture (4, 4a, 4b) sur au moins 50 % du périmètre de l'ouverture.

9. Composant électronique selon la revendication 8, **caractérisé en ce que** le deuxième matériau (2, 2a) en forme de couche délimite ladite au moins une ouverture (4, 4a, 4b) sur 100 % du périmètre de l'ouverture.

10. Composant électronique selon la revendication 8, **caractérisé en ce que** ladite au moins une ouverture est disposée dans la zone de bordure du deuxième matériau (2, 2a) en forme de couche et occasionne un prolongement du périmètre du deuxième matériau (2, 2a) en forme de couche.

11. Composant électronique selon les revendications 9 et 10, **caractérisé en ce qu'**au moins une ouverture (4, 4a, 4b) est disposée à l'intérieur du deuxième matériau (2, 2a) en forme de couche et au moins une autre ouverture est disposée dans la zone de bordure du deuxième matériau (2, 2a) en forme de couche.

12. Composant électronique selon l'une quelconque des revendications 1 à 11, **caractérisé en ce que** ladite au moins une ouverture (4, 4a, 4b) dans sa section maximale, par référence au sens perpendiculaire à la surface du substrat (1), possède une largeur dans la plage de 0,5 à 200 µm, en particulier dans la plage de 0,5 à 2,5 µm.

13. Composant électronique selon l'une quelconque des revendications 1 à 12, **caractérisé en ce que** le deuxième matériau (2, 2a) a une épaisseur de couche dans la plage de 1 à 200 nm.

14. Composant électronique selon l'une quelconque des revendications 1 à 13, **caractérisé en ce que** le troisième matériau (3, 3b) a une épaisseur de couche correspondant à au moins 10 % de l'épaisseur de couche du deuxième matériau (2, 2a).

15. Composant électronique selon l'une quelconque des revendications 1 à 14, **caractérisé en ce que** des ouvertures sont réalisées sur 5 à 50 %, en particulier 5 à 10 % d'une surface totale du deuxième matériau.

16. Composant électronique selon l'une quelconque des revendications 1 à 15, **caractérisé en ce que** le deuxième matériau (2, 2a) possède à chaque emplacement, par référence au sens perpendiculaire à la surface du substrat (1), une largeur qui s'écarte de moins de 25 % de la largeur du deuxième matériau (2, 2a) dans les autres zones.

17. Composant électronique selon l'une quelconque des revendications 1 à 16, **caractérisé en ce que** le deuxième matériau (2, 2a) est électroconducteur, en particulier est formé par un métal, un polymère conducteur, une colle conductrice, une substance conductrice avec des particules anorganiques conductrices dans une matrice polymère ou par une pâte/encre contenant des particules électroconductrices.

18. Composant électronique selon la revendication 17, **caractérisé en ce que** le deuxième matériau (2, 2a) remplit la fonction d'une première électrode.

19. Composant électronique selon la revendication 18, **caractérisé en ce que** ledit composant comporte, en outre, une deuxième électrode qui comporte également des ouvertures en vue d'augmenter sa flexibilité.

20. Composant électronique selon l'une quelconque des revendications 1 à 19, **caractérisé en ce que**, par référence au sens perpendiculaire à la surface du substrat (1), un deuxième matériau supplémentaire en forme de couche suit le troisième matériau (3, 3b) en forme de couche, **en ce qu'**une couche supplémentaire suit le deuxième matériau supplémentaire, ledit deuxième matériau supplémentaire comportant également au moins une ouverture, par l'intermédiaire de laquelle le troisième matériau (3, 3b) est relié à la couche supplémentaire en vue d'augmenter l'adhérence du deuxième matériau supplémentaire sur la couche supplémentaire.

21. Composant électronique selon la revendication 17 ou 18, **caractérisé en ce que** le deuxième matériau (2, 2a) est un matériau multicouche, en particulier constitué de plusieurs couches métalliques et/ou de plusieurs couches polymères et/ou de plusieurs couches de pâte/encre.

22. Composant électronique selon l'une quelconque des revendications 1 à 21, **caractérisé en ce que** le troisième matériau (3, 3b) forme la couche fonctionnelle électrique organique imprimée, réalisée dans un matériau électroconducteur ou un matériau semi-conducteur.

23. Composant électronique selon l'une quelconque des revendications 1 à 22, **caractérisé en ce que** le deuxième matériau (2, 2a) comporte au moins deux ouvertures (4, 4a, 4b), lesdites au moins deux ouvertures (4, 4a, 4b) ayant la même section, par référence au sens perpendiculaire à la surface du substrat (1).

24. Composant électronique selon l'une quelconque des revendications 1 à 22, **caractérisé en ce que** le deuxième matériau (2, 2a) comporte au moins deux ouvertures (4, 4a, 4b), lesdites au moins deux ouvertures (4, 4a, 4b) ayant au moins une section différente, par référence au sens perpendiculaire à la surface du substrat (1).

25. Composant électronique selon l'une quelconque des revendications 1 à 24, **caractérisé en ce que** ledit composant électronique est réalisé sous la forme d'un composant semi-conducteur organique, en particulier un transistor à effet de champ (OFET), sous la forme d'une diode organique, sous la forme d'un condenseur organique avec une capacité commandée en tension, sous la forme d'une résistance organique ou sous la forme d'un système électroconducteur organique.

26. Composant électronique selon l'une quelconque des revendications 1 à 25, **caractérisé en ce que** la couche fonctionnelle électrique organique imprimée, en matériau électroconducteur ou en matériau semi-conducteur, est formée au moyen d'un liquide, en particulier par une suspension, émulsion ou une solution.

27. Composant électronique selon l'une quelconque des revendications 1 à 26, **caractérisé en ce qu'**une couche fonctionnelle électrique supplémentaire en matériau électroconducteur ou en matériau semi-conducteur est formée par séparation par l'intermédiaire d'une phase gazeuse, en particulier par métallisation sous vide ou pulvérisation cathodique.

28. Composant électronique selon l'une quelconque des revendications 1 à 27, **caractérisé en ce que** la couche fonctionnelle électrique en matériau électroconducteur ou en matériau semi-conducteur est structurée par laser ou photolithographie.

29. Composant électronique selon l'une quelconque des revendications 1 à 28, **caractérisé en ce que** la couche fonctionnelle couche fonctionnelle électrique organique imprimée électrique en matériau électroconducteur ou en matériau semi-conducteur matériau semi-conducteur est formée dans un procédé de fabrication continu.
